# EUROPEAN PATENT APPLICATION

(11) **EP 2 179 946 A1**
(43) Date of publication of application: **28.04.2010**
(21) Application number: 08740738.3
(22) Date of filing: 21.04.2008
(51) Int. Cl.: B65G 47/84

(54) **CONTAINER CONVEYANCE APPARATUS**

(71) Applicant: Toyo Seikan Kaisha, Ltd., Tokyo 100-8522 (JP)
(72) Inventor: KOISHI, Ryousuke, Yokohama-shi Kanagawa 230-0001 (JP); GONDA, Toshiaki, Yokohama-shi Kanagawa 230-0001 (JP)
(74) Representative: Müller-Boré & Partner Patentanwälte
(86) International application number: PCT/JP2008/057696
(87) International publication number: WO 2009/130751

(57) **Abstract**

[Problems] To decrease the area for installing a container conveyer passage that has container hand-over devices on the way of the conveyer passage.

[Means for Solution] A container conveyer device including a conveyer passage that has a container feed position d where containers are received and a container discharge position i where the containers are handed over, and for conveying the containers from the container feed position d up to the container discharge position i, the container conveyer device, further, having container hand-over positions f, h where the containers that are once taken out from the conveyer passage are returned back again to the conveyer passage on the way of the container conveyer passage. A conveyer wheel 4 includes an inner conveyer passage 9 and an outer conveyer passage 10 that rotate about a rotary shaft, and conveyer hand-over means 5, 6 that hand over the containers between the inner conveyer passage 9 and the outer conveyer passage 10, and works to return the containers back to the outer conveyer passage 10 at the hand-over position h after the containers are taken out from the inner conveyer passage 9 at the container hand-over position f.

## Description

### Technical Field:

This invention relates to a container conveyer device equipped with a container conveyer passage along which there are container-treating steps, enabling the containers to be handed over to the container-treating steps from the conveyer passage on the way of round trips.

### Background Art:

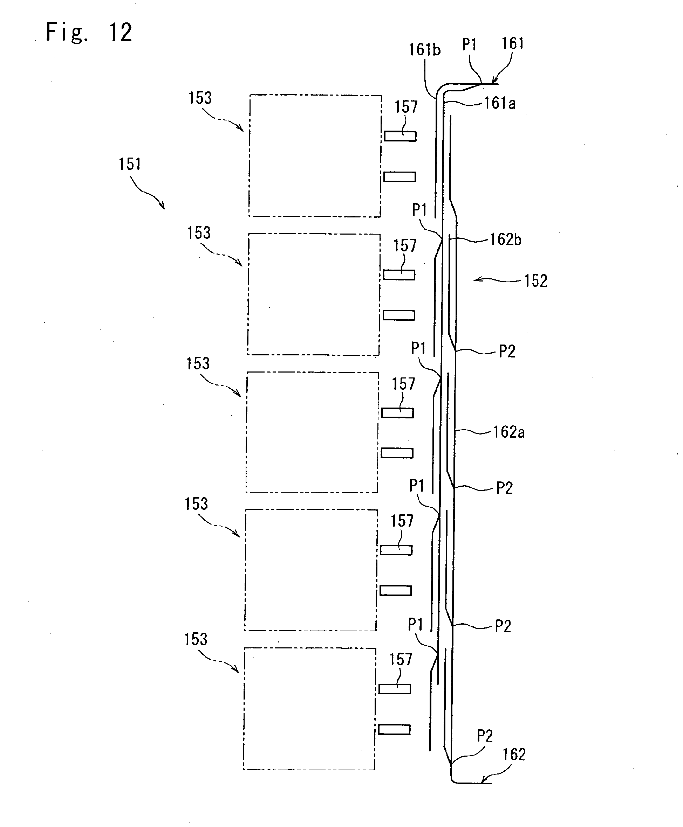

Fig. 12 illustrates a system 151 using a conventional container conveyer device.
The system 151 has a plurality of (five) devices 153 along a conveyer 152 that extends straight.
The conveyer 152 includes a container feed conveyer passage 161 and a container discharge conveyer passage 162. The container feed conveyer passage 161 includes a main line 161a, conveyer passage change-over points at five places designated at P1, and five branch lines 161b branched from the change-over points P1. Similarly, the container discharge conveyer passage 162 includes a main line 162a, conveyer passage change-over points at four places designated at P2, and four branch lines 162b that meet the main line 162a at the change-over points P2.
Between the conveyer 152 and the devices 153, conveyer hand-over devices 157 are arranged to take a container from the conveyer 152 and to return it back to the conveyer 152. The container that is treated is returned back to the conveyer 152 and is conveyed to the next step.

The following patent document 1 teaches that in a container conveyer device of a prior art, the containers are arranged in a row on a conveyer line, and electric charge portions are arranged on the way of the conveyer passage for forming a plurality of films. In order to treat a number of containers, however, the patent document 1 teaches that the number of the discharge portions must be increased.
Arrangement of the plurality of discharge portions on the way of the conveyer passage, however, causes the device to become bulky making it difficult to shorten the time for forming the films. According to an embodiment of the patent document 1, further, the containers conveyed in a row on the conveyer passage are held in a circular cassette that is capable of holding a plurality of containers, and many containers are conveyed into a film-forming chamber to form films on the containers.
Patent document 1: Japanese Unexamined Patent Publication JP-A-2005-105306

### Disclosure of the Invention:

### Problems to be Solved by the Invention:

To convey the containers, the conveyer 152 shown in Fig. 12 is divided into the container feed conveyer passage 161 and the container discharge conveyer passage 162. Here, to flow the containers from the main line 161a to the branch lines 161b or from the branch lines 162b to the main line 162a, it becomes necessary to provide the conveyer passage change-over points P1, P2; i.e., conveyer passage change-over devices (not shown) are required in many number. Therefore, the change-over timings for conveying the containers become complex making it difficult to increase the speed for conveying the containers.
When, for example, the containers are preferentially fed from the upstream devices 153, successively, the containers are not often fed to the downstream devices 153 making it difficult to conduct the processing to meet operating capability.
When the treating devices such as the devices 153 are arranged in a plural number (five) in series on the way of the conveyer 152 along the conveyer 152 as described above, the system 151 becomes long in the direction of the conveyer 152 making it difficult to effectively utilize the area where it is installed resulting in an increase in the area where the system as a whole is installed. It is also allowable to install a conveyer for each device 153. In this case, however, the conveyers are necessary in a number equal to the number of the devices 153 making it, still, difficult to decrease the area for installation.
The present invention was accomplished in view of the above circumstances, and has an object of providing a container conveyer device which is capable of increasing the speed for conveying the containers on a container conveyer passage having container hand-over devices on the way of the container conveyer passage as well as decreasing the area on where a system as a whole is installed.

### Means for Solving the Problems:

In order to achieve the above object, the container conveyer device of the present invention including a container feed position for receiving containers, a container discharge position for handing over the containers, a conveyer passage for conveying the containers from said container feed position up to said container discharge position, and a container hand-over position where the containers are once taken out from said conveyer passage and the containers are returned back again to said conveyer passage on the way of said conveyer passage, wherein, said conveyer passage includes an inner conveyer passage that rotates about a rotary shaft, an outer conveyer passage arranged on the outer circumferential side thereof on the same shaft, container feed means for feeding the containers at the container feed position on either said inner conveyer passage or said outer conveyer passage, and container discharge means for discharging the containers at the container discharge position on the other conveyer passage, the conveyer passage, further, including container hand-over means for returning the containers back to the other conveyer passage after the containers are taken out from the one conveyer passage at the container hand-over positions.
In the container conveyer device, the inner conveyer passage and the outer conveyer passage are independently controlled.
In the container conveyer device, the outer conveyer passage is arranged at a position of height equal to, or lower than, the position of height of the inner conveyer passage.
In the container conveyer device, the container feed means includes a rotary container feed wheel having container support portions, and has, at the container feed position, a contact portion between a container conveyer track of the container feed wheel and a container conveyer track of the one conveyer passage, to hand over the containers at the contact portion, and the container discharge means includes a rotary container discharge wheel having container support portions, and has, at the container discharge position, a contact portion between a container conveyer track of the container discharge wheel and a container conveyer track of the other conveyer passage, to hand over the containers at the contact portion.
In the container conveyer device, a plurality of said container hand-over means are provided along the circumferential direction of said conveyer passage.

### Effects of the Invention:

In the container conveyer device of the present invention, the conveyer passage has the inner conveyer passage that rotates about the rotary shaft, the outer conveyer passage arranged on the outer circumferential side thereof, the conveyer feed means for feeding the containers to either the inner conveyer passage or the outer conveyer passage, and container discharge means for discharging the containers to the other conveyer passage, so that the containers are returned back to the other conveyer passage after the containers are taken out from the one conveyer passage at the container hand-over position. Further, the inner conveyer passage and the outer conveyer passage are independently controlled so that the containers can be fed and discharged at separate timings. It is, therefore, made possible to convey the containers at high speeds. More closely, unlike the conventional device (Fig. 12), the container conveyer device does not require a plurality of branch passages or conveyer passage change-over points, does not require the time such as waiting for the change over of the container conveyer passages, and makes it possible to shorten the time for feeding and discharging the containers. Upon increasing the speed of conveyance, the containers can be conveyed to meet the treating capability of the device contributing to improving the production efficiency.
Despite there are a plurality of container-treating devices (vapor deposition devices) on the way of the conveyer passage, the system as a whole does not extend straight, and the area for installation can be effectively utilized. The conventional device was provided with the container feed conveyer passage and the container discharge conveyer passage or, substantially, with four conveyer passages inclusive of branch passages to convey the containers requiring an increased area for installation. The present invention, on the other hand, requires the container feed conveyer passage and the discharge conveyer passage only, though the conveyer passages have dissimilar shapes, making it possible to decrease the area for installation.

### Brief Description of the Drawings:

[Fig. 1] is a schematic plan view of a vapor deposition system equipped with a container conveyer device of the present invention.
[Fig. 2] is a schematic enlarged plan view illustrating the vapor deposition system of Fig. 1 in a simplified manner.
[Fig. 3] is a plan view of the container conveyer device in the vapor deposition system of Fig. 1.
[Fig. 4] is a plan view illustrating a driving system for the container conveyer device in the vapor deposition system of Fig. 1.
[Fig. 5] is a sectional view on the container feed side of the container conveyer device in a direction of a line A-A in Fig. 4.
[Fig. 6] is a sectional view on the container feed side of the container conveyer device in a direction of a line B-B in Fig. 4.
[Fig. 7] is a sectional view on the container feed side of the container conveyer device in a direction of a line C-C in Fig. 4.
[Fig. 8] is an enlarged plan view of a vapor deposition device in the vapor deposition system of Fig. 1.
[Fig. 9] is a sectional view on the container discharge side of the container conveyer device in a direction of a line D-D in Fig. 4.
[Fig. 10] is a sectional view on the container discharge side of the container conveyer device in a direction of a line E-E in Fig. 4.
[Fig. 11] is a sectional view on the container discharge side of the container conveyer device in a direction of a line F-F in Fig. 4.
[Fig. 12] is a schematic plan view of a conventional vapor deposition system.

### Description of Reference Numerals:

- 1(1a to 1e): vapor deposition devices
- 2: feed conveyer
- 3: container feed wheel
- 3a: rotary shaft
- 3b, 7b: rotary wheels
- 3c: gear
- 4: conveyer wheel
- 5, 6: container hand-over devices
- 7: container discharge wheel
- 7a, 48a: rotary shafts
- 7c, 47a, 47b, 68c: pulleys
- 8: discharge conveyer
- 9: inner conveyer passage
- 10: outer conveyer passage
- 14: turntable
- 15: vapor deposition units
- 24: pressure-reducing chambers
- 25: containers
- 34: microwave oscillators
- 39: timing screw
- 39a: groove
- 40: inner guide
- 40a: guide plates
- 40b: container limiting portions
- 41: outer guide
- 41a: bottom plate
- 41b: guide plates
- 42: base plate for feed wheel
- 43, 54: brackets
- 44: support rod
- 45, 63: bearings
- 46, 68: servo motors
- 46a: main shaft
- 46b, 68b: main gears
- 48: intermediate gear body
- 48a: rotary shaft
- 48b: intermediate gear
- 49, 76: belts
- 50, 60, 70: inner guides
- 50a: container support portions
- 50b, 60b: bottom plates
- 51, 61, 71: container outer guides
- 51a, 64b, 74b: guide plates
- 53: base plate for supporting conveyer wheel
- 54a,: 64a support plates
- 55: inner wheel guide member
- 56: inner wheel gear
- 57, 67: bearings
- 60a: container support portions
- 62: base plate for take-out wheel
- 64: support frame
- 65: outer wheel guide member
- 66: outer wheel gear
- 68a: main shaft
- 70a: container limiting portions
- d: container feed position
- i: container discharge position
- f, h: container hand-over positions

### Best Mode for Carrying Out the Invention:

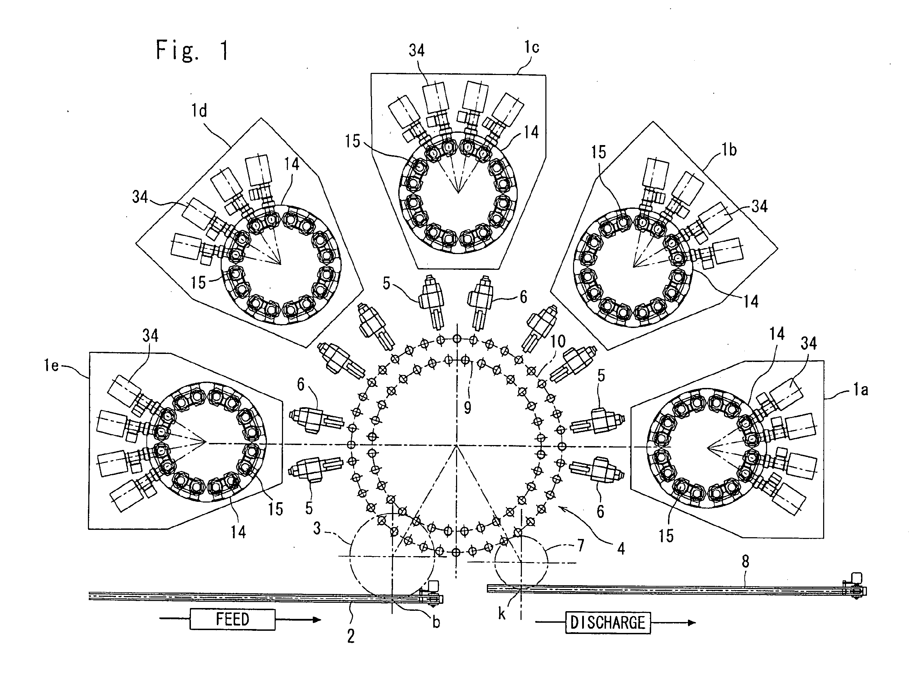

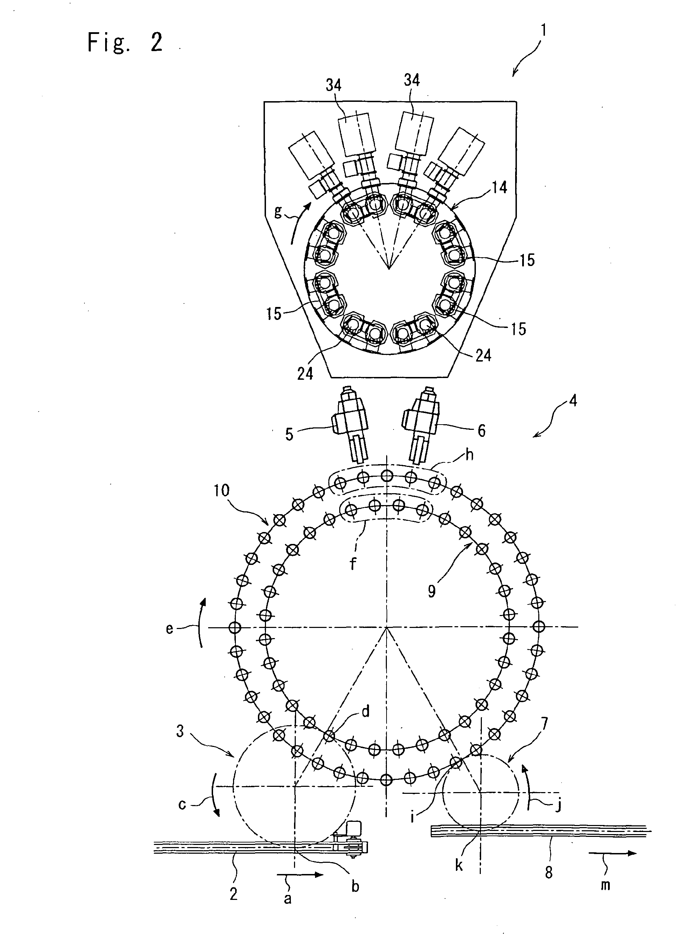

Fig. 1 is a plan view of a vapor deposition system for containers equipped with a container conveyer device according to the present invention, and Fig. 2 is an enlarged plan view of the vapor deposition system (only one vapor deposition device 1 is shown here due to the space of the drawing).
The vapor deposition system works to deposit the vapor of a functional starting material on the inner surfaces of the containers by utilizing microwaves while the containers move through the vapor deposition system from the upstream side thereof to the downstream side thereof. The containers 25 flow to a feed conveyer 2 positioned on the upstream of the vapor deposition system, container feed wheel 3, conveyer wheel 4, container hand-over devices (delivery robots) 5, 6, and to the vapor deposition device 1, and are returned back again to the container hand-over devices 5, 6 and to the conveyer wheel 4, and, further, flow from the conveyer wheel 4 to a container discharge wheel 7 and to a discharge conveyer 8. In this embodiment, the side of the feed conveyer 2 is regarded to be the upstream side and the side of the discharge conveyer 8 is regarded to be the downstream side along the flow of the steps for treating the containers 25.

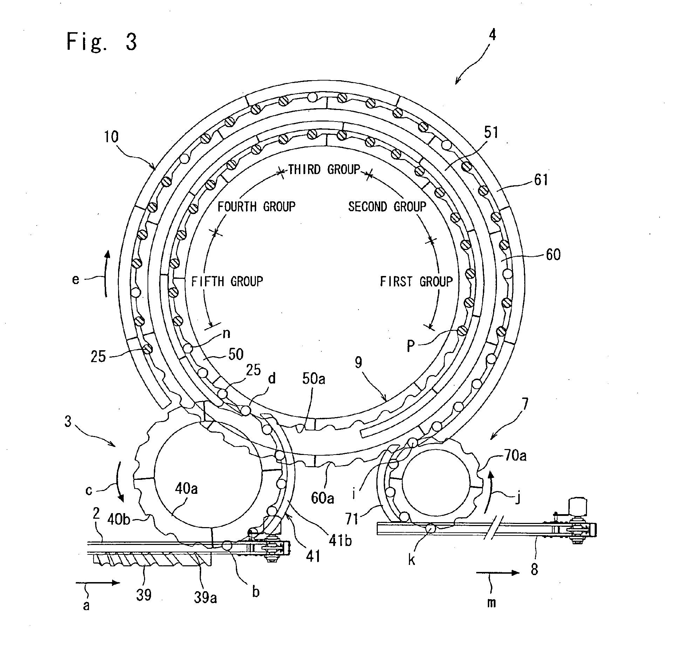

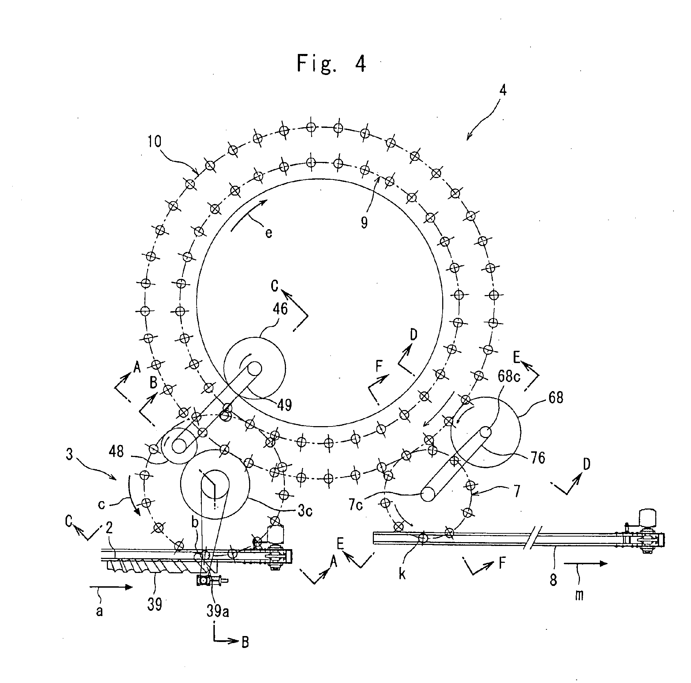

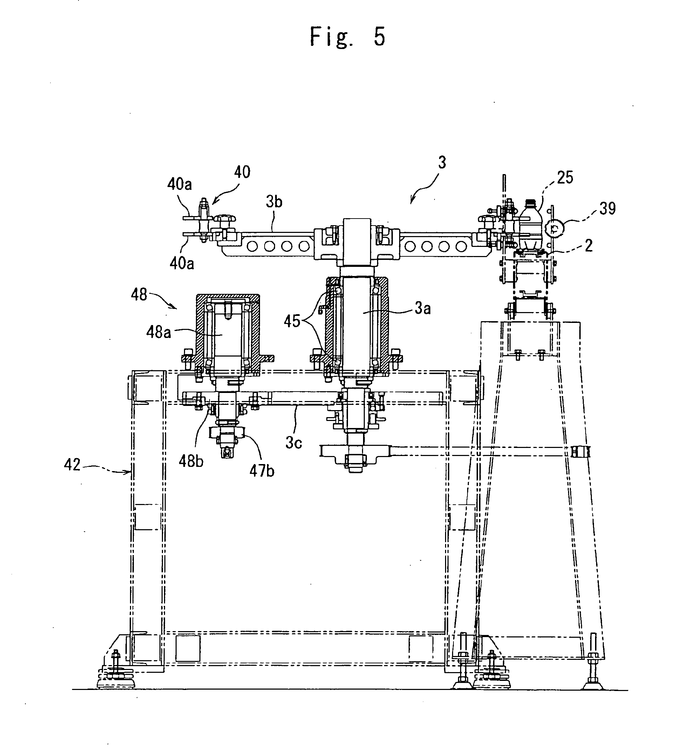

Referring to Fig. 3 to Fig. 5, the feed conveyer 2 conveys the containers 25 in a linear direction of an arrow a in an erected attitude with their openings facing upward. A timing screw 39 is provided on the downstream of the feed conveyer 2, and the containers 25 are conveyed upon being contacted to a groove 39a of the timing screw 39 and are handed at a hand-over point b over to the container feed wheel 3.
The container feed wheel 3 has a rotary shaft 3a that is rotatably supported by a base plate 42 for feed wheel via a bearing 45. A wheel surface of a rotary wheel 3b is arranged in a horizontal direction on the upper part of the rotary shaft 3a, and a container inner guide 40 is provided at the outer circumferential portion thereof in the radial direction. The inner guide 40 has annular guide plates 40a, and container limiting portions 40b of the shape of a curved groove are formed in the outer circumferential side surfaces of the guide plates 40a. The container limiting portions 40b work in cooperation with the groove 39a of the timing screw 39 enabling the container feed wheel 3 to receive the containers 25. The guide plates 40a are provided maintaining a gap in the up-and-down direction so as to support an upper part and a lower part of the container at an intermediate position thereof.

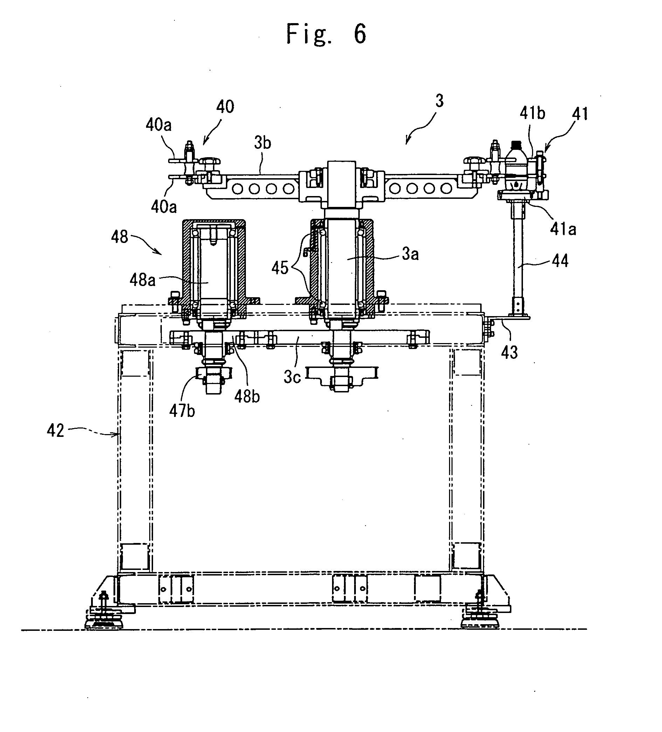

The container feed wheel 3 is provided with an outer guide 41, and the containers 25 are conveyed between the inner guide 40 limited by the limiting portions 40b and the outer guide 41. The outer guide 41 is arranged between a hand-over point b and a hand-over point d shown in Fig. 2.
Referring to Fig. 6, the outer guide 41 is supported by a support rod 44 erected on an L-shaped bracket 43 which is attached to a side wall of the base plate 42 for feed wheel. The outer guide is provided with a bottom plate 41a for supporting the container 25 and arcuate guide plates 41b for supporting the peripheral walls of the containers. The guide plates 41b are arranged maintaining a gap in the up-and-down direction.

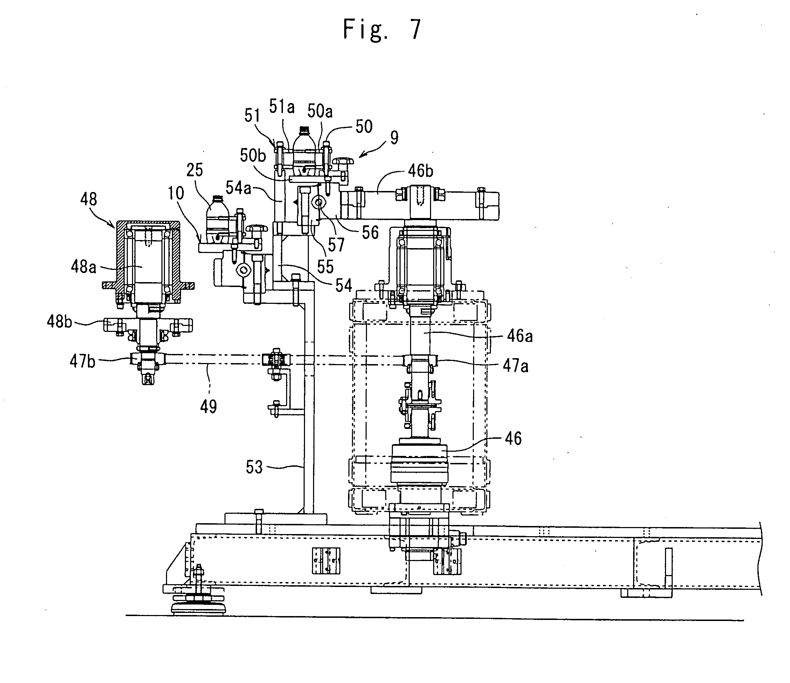

Referring to Fig. 6 and Fig. 7, the container feed wheel 3 rotates being driven by a servo motor 46. That is, the servo motor 46 is arranged at a lower portion of the conveyer wheel 4. A belt 49 runs between a pulley 47a at an intermediate position of a main shaft 46a thereof in the up-and-down direction and a pulley 47b attached to a lower part of a rotary shaft 48a of an intermediate gear body 48 provided for the base plate 42 for feed wheel. An intermediate gear 48b is attached to the rotary shaft 48a of the intermediate gear body 48, and is in mesh with a gear 3c that is attached to the rotary shaft 3a of the container feed wheel 3. Therefore, the driving force of the servo motor 46 is transmitted to the container feed wheel 3 in order of servo motor 46, belt 49, intermediate gear 48b and gear 3c, and the rotary wheel 3b rotates.

Referring to Fig. 2 and Fig. 3, the conveyer wheel 4 has a circular inner conveyer passage 9 and an outer conveyer passage 10 which are in concentric with the rotary shaft, the inner and outer conveyer passages 9 and 10 rotating in the clockwise direction indicated by an arrow e.
The inner conveyer passage 9 is provided with arcuate inner guides 50, and container support portions 50a of the shape of a curved groove are provided in a plural number in the outer circumferential side surface thereof maintaining an equal distance in the circumferential direction. The circular track of the container support portions 50a comes in contact with the circular track of the container feed wheel 3 at the hand-over position d, and works in cooperation with the container limiting portions 40b of the container feed wheel 3, so that the container support portions 50a receive the containers at the hand-over position d.

Referring to Fig. 7, the inner conveyer passage 9 is supported on a base plate 53 for supporting the conveyer wheel or, more closely, is supported by an annular inner wheel guide member 55 fixed to an upper surface of a bracket 54 of a U-shape in cross section that is placed on the base plate 53 for supporting the conveyer wheel. That is, an inner wheel gear 56 of the inner conveyer passage 9 is arranged in the inner circumferential surface of the wheel gear guide member 55 so as to freely slide therein, and an annular bearing 57 is provided at the sliding portion so that the inner wheel gear 56 rotates sliding in the inner circumferential surface of the inner wheel guide member 55.
The inner conveyer passage 9 is provided with a bottom plate 50b for placing the containers thereon, and the inner guides 50 are supported on the bottom plate 50b. The inner guides 50 are provided in a number of two maintaining a gap in the up-and-down direction so as to support the upper part and the lower part of the containers at the intermediate position thereof.

Teeth are formed in the inner circumferential surface of the inner wheel gear 56 and are in mesh with a main gear 46b attached to an upper part of the main shaft 46a of the servo motor 46 so as to be rotated by the driving force of the servo motor 46.
A support plate 54a is provided at an upper part of the bracket 54, and an outer guide 51 is arranged at a further upper part of the support plate. The outer guide 51 is provided with arcuate guide plates 51a for supporting the circumferential wall portions of the containers. The guide plates 51a are provided in a number of two maintaining a gap in the up-and-down direction. The outer guide 51 is arranged starting from the hand-over position d of the inner conveyer passage 9 up to the container discharge wheel 7 (see Fig. 3).
As shown in Fig. 2, the conveyer wheel 4 conveys the containers up to the hand-over area f of the inner conveyer passage 9 so as to hand the containers over to the hand-over devices 5, 6. The hand-over devices 5, 6 can turn (reversely turn) toward the side of the vapor deposition device 1 about the rotary shaft.

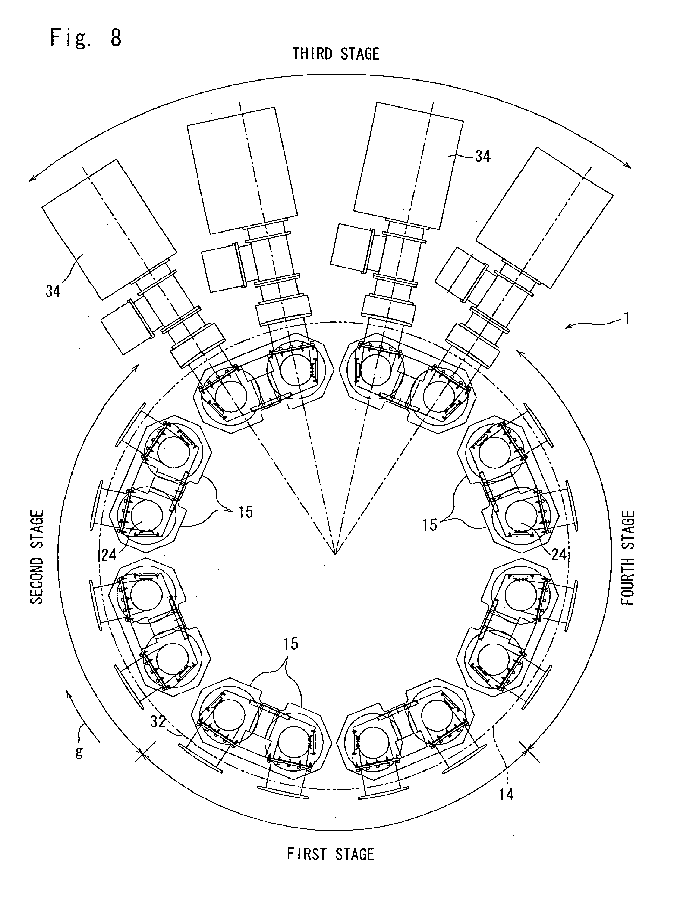

Fig. 8 is an enlarged sectional view of the vapor deposition device 1.
The vapor deposition device 1 is provided with a turntable 14 which rotates in the clockwise direction as indicated by an arrow g. A plurality of vapor deposition units 15 are arranged on the outer circumferential portion of the turntable 14. In this embodiment, the vapor deposition units 15 are arranged in a number of 16 in the circumferential direction of the turntable 14, wherein the pairs are each constituted by two vapor deposition units 15 and are integrally arranged. The vapor deposition units 15 can move along a circular track in concentric accompanying the rotary motion of the turntable 14.
The vapor deposition unit 15 is provided with a pressure-reducing chamber 24 of a circular shape in transverse cross section and to which a vacuum pump that is not shown is connected to reduce the pressure in the chamber. The vapor deposition unit 15 is provided with a waveguide 32 communicated with the pressure-reducing chamber 24. A microwave oscillator 34 is present near the waveguide 32.

The microwave oscillators 34 are fixed on the outer side of the turntable 14, and are provided in a number of four in this embodiment. The microwave oscillators 34 are arranged at positions on the side opposite to the hand-over devices 5, 6 in the radial direction of the turntable 14. The four (plurality of) microwave oscillators 34 are arranged being corresponded to the plurality of (four) vapor deposition units 15 consecutively arranged in the circumferential direction. Therefore, the four adjacent containers 25 can be vapor-deposited simultaneously.
The container hand-over devices 5, 6 work to feed the containers 25 into the pressure-reducing chambers 24 as well as to take them out therefrom. The hand-over devices 5, 6 can take out or introduce the containers 25 from or into the four vapor deposition units 15 arranged at a position indicated as a first stage in Fig. 8. In a hand-over area h of the conveyer wheel 4 shown in Fig. 2, the hand-over devices 5, 6 hand the containers 25 over to the outer conveyer passage 10.

Referring to Fig. 2 and Fig. 3, arcuate inner guides 60 are provided for the outer conveyer passage 10, and container support portions 60a of the shape of a curved groove are formed in a plural number in the outer circumferential portions of the inner guides 60 in the circumferential direction.
The outer conveyer passage 10 rotates in the clockwise direction of an arrow e and hands the containers over to the container discharge wheel 7 at a hand-over position i. The circular track of the container support portions 60a comes in contact with the circular track of the container discharge wheel 7 at the hand-over position i where the containers are handed from the container support portions 60a over to the container discharge wheel 7.
The container support portions 60a are arranged in a plural number in the circumferential direction of the outer conveyer passage 10 maintaining an equal distance. The container support portion 60a are formed maintaining the same pitch as that of the container support portions 50a of the inner conveyer passage 9.

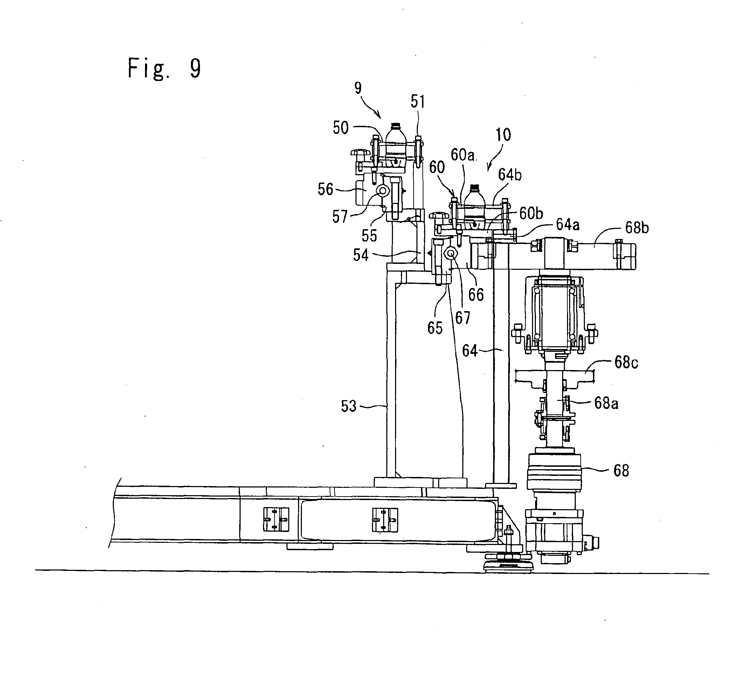

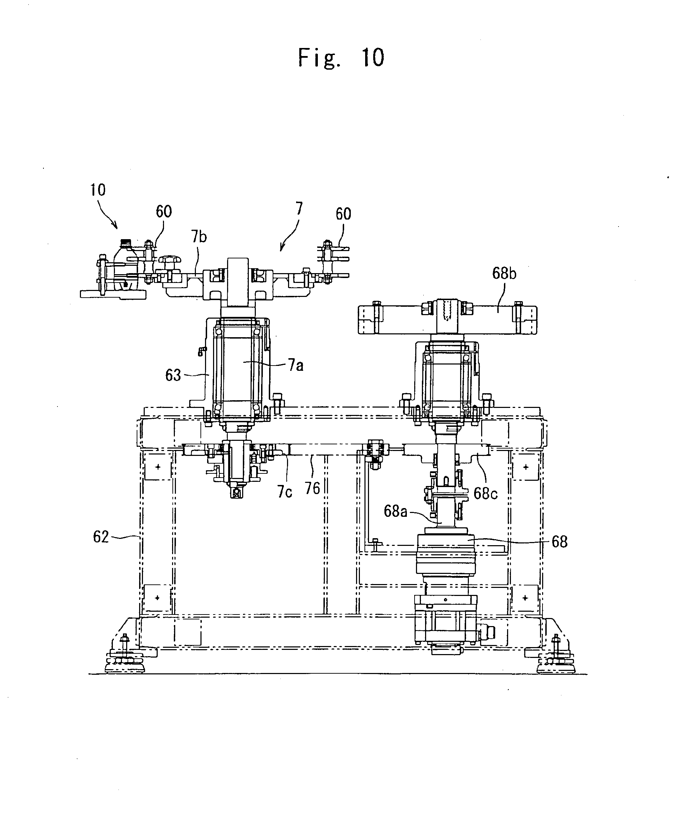

Referring to Fig. 9 and Fig. 10, the outer conveyer passage 10 is supported on the base plate 53 for supporting the conveyer wheel or, more closely, is supported by an outer wheel guide member 65 attached to the base plate 53 for supporting the conveyer wheel. That is, an outer wheel gear 66 of the outer conveyer passage 10 is arranged along the outer circumferential surface of the outer wheel guide member 65 so as to freely slide therein, and an annular bearing 67 is provided at the sliding portion so that the outer wheel gear 66 rotates relative to the outer circumferential surface of the outer wheel guide member 65.
The outer conveyer passage 10 is provided with a bottom plate 60b for supporting the containers, and the inner guides 60 are supported on the bottom plate 60b. The inner guides 60 are provided maintaining a gap in the up-and-down direction so as to support the upper part and the lower part of the containers at the intermediate position thereof.

Teeth are formed in the outer circumferential surface of the outer wheel gear 66 and are in direct mesh with a main gear 68b attached to an upper part of the main shaft 68a of the servo motor 68, and the outer wheel gear 66 is rotated by the driving force of the servo motor 68.
A support frame 64 is attached to the side portion of the base plate 53 for supporting the conveyer wheel, a support plate 64a is provided at an upper part of the support frame 64, and an outer guide 61 is arranged at a further upper part of the support plate 64a. The outer guide 61 is provided with arcuate guide plates 64b for supporting the circumferential wall portions of the containers 25. The guide plates 64b are provided maintaining a gap in the up-and-down direction. The outer guide 61 is arranged starting from the position of the container feed wheel 3 up to the hand-over position i which is an end point(see Fig. 3).
As described above, the inner conveyer passage 9 and the outer conveyer passage 10 are so constituted as to rotate independently from each other, the position of height of the inner conveyer passage 9 being higher than the position of height of the outer conveyer passage 10.

The container discharge wheel 7 has a rotary shaft 7a that is rotatably supported by base plate 62 for take-out wheel via a bearing 63. A rotary wheel 7b is arranged in a horizontal direction on the upper part of the rotary shaft 7a. Inner guides 70 of the form of an annular plate are provided at the outer circumferential portion of the container discharge wheel 7 facing in the horizontal direction. Container limiting portions 70a of the shape of a curved groove are formed in the outer circumferential portions of the inner guides 70 in the circumferential direction thereof.
Referring to Fig. 3, the container discharge wheel 7 is provided with an outer guide 71 on the outer circumferential side thereof, and the containers 25 are conveyed between the container limiting portions 70a and the outer guide 71 at the hand-over position i. The outer guide 71 is arranged between the hand-over point i and the hand-over point k shown in Fig. 2.
The container limiting portions 70a work in cooperation with the container support portions 60a of the outer conveyer passage 10 enabling the container discharge wheel 7 to receive the containers 25. The inner guides 70 are provided maintaining a gap in the up-and-down direction so as to support the upper part and the lower part of the containers at the intermediate position thereof. The outer guide 71 is constituted in the same manner as the outer guide 41 of the container feed wheel 3.

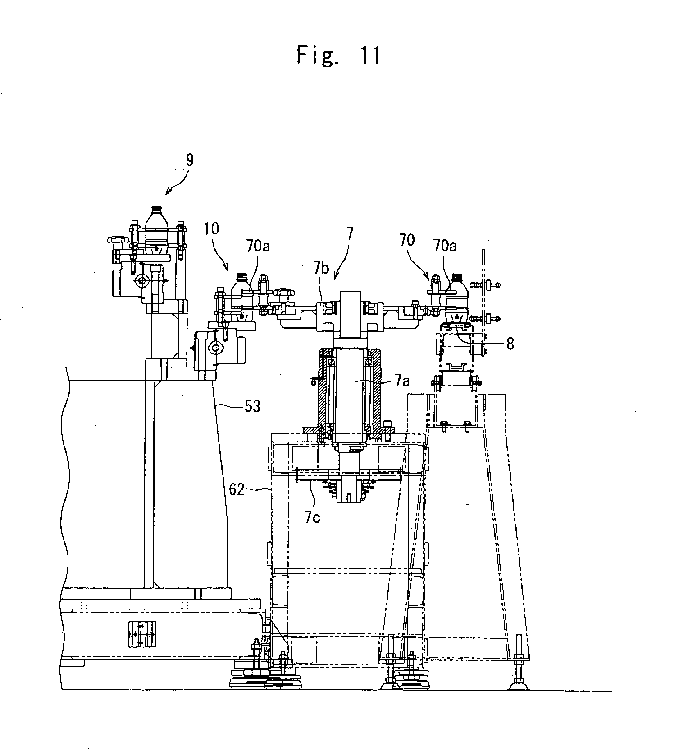

Referring to Fig. 10, the container discharge wheel 7 rotates being driven by the servo motor 68. That is, the servo motor 68 has a belt 76 that runs between a pulley 68c at an intermediate position of the main shaft 68a thereof in the up-and-down direction and a pulley 7c attached to the rotary shaft 7a of the container discharge wheel 7. The driving force of the servo motor 68 is transmitted to the container discharge wheel 7 via the belt 76, and the rotary wheel 7b rotates.
Referring to Fig. 2, the container discharge wheel 7 rotates in the counterclockwise direction of an arrow j, and the containers 25 are handed over at a hand-over position k of the discharge conveyer 8 shown in Fig. 11 extending in the tangential direction of the container discharge wheel 7 that is rotating.
The discharge conveyer 8 conveys the containers 25 in the linear direction of an arrow m.

Next, described below is an example in which the vapor deposition devices (coating devices) are arranged for the container conveyer device of the present invention.
Referring to Fig. 3, when the vapor deposition system starts operating, the containers 25 are consecutively conveyed by the feed conveyer 2 arranged at the position upstream of the vapor deposition system. At the hand-over position b of the feed conveyer 2, the containers 25 are supported between the container limiting portions 40b of inner guide 40 of the container feed wheel 3 and the guide plates 41b of the outer guide 41. Thereafter, the containers 25 are fed to the conveyer wheel 4 at the hand-over position d of the inner conveyer passage 9 of the conveyer wheel 4 of which the rotary track contacts to that of the container feed wheel 3. Thus, the container feed wheel 3 consecutively feeds the containers 25 to the inner conveyer passage 9 of the conveyer wheel 4. On the inner conveyer passage 9, the containers 25 are arranged in the container support portions 50a of the inner guide 50, and are consecutively conveyed clockwise between the inner guide 50 and the outer guide 51.

Referring to Fig. 1 and Fig. 3, the vapor deposition devices 1 are provided in a number of five on the outer side of the conveyer wheel 4 in the radial direction (Fig. 2 shows only one of them). For instance, upon arriving at the container take-out position p of the conveyer wheel 4 facing the vapor deposition device 1a positioned on the downstream side, the four containers 25 of the first group are handed over to the four vapor deposition units 15 by the hand-over devices 5, 6 of the vapor-deposition device 1a. At the same time, the containers 25 of the second group are handed over to the vapor deposition device 1b, the containers 25 of the third group are handed over to the vapor deposition device 1c, the containers 25 of the fourth group are handed over to the vapor deposition device 1d, and the containers 25 of the fifth group are handed over to the vapor deposition device 1e. After the containers 25 are handed over to the vapor deposition devices 1a to 1e, the containers 25 following the head position n of before the containers are taken out are subsequently conveyed on the inner conveyer passage 9.

Referring to Fig. 8, the turntable 14 rotates at a regular interval each by 90 degrees from the first stage toward the second stage. In the first stage, the containers 25 are handed over by the above-mentioned container hand-over devices 5, 6 (see Fig. 1). At this moment, the containers 25 conveyed from the first group up to the fifth group shown in Fig. 3 are all taken out from the inner conveyer passage 9, and are fed to the vapor deposition units 15. After the containers 25 have been handed over, the turntable 14 is turned by 90 degrees to move the vapor deposition units 15 to the second stage.

At the same time, the vapor deposition units 15 arranged in the fourth stage are moved to the first stage due to the turn of the turntable 14. When the vapor-deposited containers have not yet been held in the vapor deposition units 15 like in the initial stage of the vapor deposition work, the container hand-over devices 5, 6 work to only feed the containers 25 to the vapor deposition units 15.
At this moment, the conveyer wheel 4 works to convey the container 25 at the head position n on the inner conveyer passage 9 of before the containers are taken out, up to the container take-out position p. Thereafter, the container hand-over devices 5, 6 work to feed the containers 25 which have not yet been vapor-deposited as received from the inner conveyer passage 9 into the vapor deposition units 15 from which the containers 25 have been taken out.
When the containers 25 are vapor-deposited after one cycle has been finished, the vapor-deposited containers have been held in the pressure-reducing chambers 24. Therefore, the hand-over devices 5, 6 take out the four containers 25 in the hand-over area f of the inner conveyer passage 9, and hand the containers 25 over to the outer conveyer passage 10.
After the end of the second stage, the turntable 14 is turned by 90 degrees to move the vapor deposition units 15 to the third stage.

After the containers 25 are vapor-deposited in the third stage, the turntable 14 is, further, turned by 90 degrees to move the vapor deposition units 15 to the fourth stage.
After the fourth stage has been finished, the turntable 14 is turned by 90 degrees, the containers 25 in the vapor deposition units 15 are arranged facing the hand-over devices 5, 6, and the containers 25 are handed over to the outer conveyer passage 10.
The conveyer wheel 4 returns the containers 25 from the vapor deposition devices 1a to 1e back to the outer conveyer passage 10 through the hand-over devices 5, 6.

The outer conveyer passage 10 rotates in the direction of an arrow e shown in Fig. 2 to convey the containers 25, and hand the containers 25 over to the container discharge wheel 7 at a hand-over position i. The containers 25 are stably conveyed between the inner guide 60 and the outer guide 61.
At the hand-over position i, the container limiting portions 70a of the inner guide 70 of the container discharge wheel 7 work in cooperation with the container support portions 60a of the outer conveyer passage 10 so that the containers 25 can be smoothly handed over from the outer conveyer passage 10 to the container discharge wheel 7. The container discharge wheel 7 stably conveys the containers 25 between the inner guide 70 and the outer guide 71.
The containers 25 are turned by the container discharge wheel 7 in the counterclockwise direction of an arrow j, and are handed over to the discharge conveyer 8 at a hand-over position k.
The discharge conveyer 8 conveys the containers 25 in the linear direction of an arrow m and feeds the containers 25 to the next step.

In this embodiment as described above, the conveyer wheel 4 is rotatably arranged, and the conveyer passage is provided as inner and outer two routes in the radial direction, i.e., divided into the inner conveyer passage 9 on the side of feeding the containers 25 and the outer conveyer passage 10 on the side of taking out the containers, making it possible to convey the containers 25 at a high speed. That is, a plurality of branch passages or conveyer passage change-over points are not required unlike that of the conventional device shown in Fig. 12. Therefore, no such time is required as waiting for the change over of the container conveyer passages, and the time for feeding and discharging the containers can be shortened.
Further, since the plurality of vapor deposition devices 1a to 1e which are the container-treating devices are arranged in the circumferential direction of the circular conveyer wheel 4, the system as a whole does not extend in a linear direction. Therefore, the area for installation can be effectively utilized and can be decreased by about 30% as compared to that of the conventional systems.

Though the invention was described above in detail by way of an embodiment with reference to the accompanying drawings, it should be noted that the invention is in no way limited to the above embodiment only but can be altered or modified in various other ways without departing from the scope of the invention.
In the above embodiment, the hand-over devices 5, 6 work to hand over four containers 25 from the four vapor deposition units 15. However, the number of the containers 25 to be handed over by the hand-over devices 5, 6 is not limited to a plural number, but only one container may be handed over.
In the above embodiment, robots were used as the hand-over devices 5, 6 as means for handing over the containers.
According to the invention, however, any other means may be used instead of the robots.

## Claims

1. A container conveyer device including a container feed position for receiving containers, a container discharge position for handing over the containers, a conveyer passage for conveying the containers from said container feed position up to said container discharge position, and a container hand-over position where the containers are once taken out from said conveyer passage and the containers are returned back again to said conveyer passage on the way of said conveyer passage,
wherein:
said conveyer passage includes an inner conveyer passage that rotates about a rotary shaft, an outer conveyer passage arranged on the outer circumferential side thereof on the same shaft, container feed means for feeding the containers at the container feed position on either said inner conveyer passage or said outer conveyer passage, and container discharge means for discharging the containers at the container discharge position on the other conveyer passage;
the conveyer passage, further, including container hand-over means for returning the containers back to said other conveyer passage after the containers are taken out from said one conveyer passage at said container hand-over positions.

2. The container conveyer device according to claim 1,
wherein said inner conveyer passage and said outer conveyer passage are independently controlled.

3. The container conveyer device according to claim 1 or 2,
wherein said outer conveyer passage is arranged at a position of height equal to, or lower than, the position of height of said inner conveyer passage.

4. The container conveyer device according to any one of claims 1 to 3, wherein said container feed means includes a rotary container feed wheel having container support portions, and has, at the container feed position, a contact portion between a container conveyer track of said container feed wheel and a container conveyer track of said one conveyer passage, to hand over the containers at said contact portion, and said container discharge means includes a rotary container discharge wheel having container support portions, and has, at the container discharge position, a contact portion between a container conveyer track of said container discharge wheel and a container conveyer track of said other conveyer passage, to hand over the containers at said contact portion.

5. The container conveyer device according to any one of claims 1 to 4, wherein a plurality of said container hand-over means are provided along the circumferential direction of said conveyer passage.

6. The container conveyer device according to any one of claims 1 to 5, wherein coating devices are arranged on the outer circumferences of said container hand-over means to apply coatings onto the surfaces of the containers.
